# EUROPEAN PATENT SPECIFICATION

(11) **EP 1 250 730 B1**
(45) Date of publication and mention of the grant of the patent: **07.05.2008**
(21) Application number: 00901545.4
(22) Date of filing: 07.01.2000
(51) Int. Cl.: H01Q 23/00, H04B 17/00, G01R 29/10

(54) **AN RF ANTENNA DETECTOR CIRCUIT**
HF- ANTENNENDETEKTORSCHALTUNG
CIRCUIT DE DETECTION ET ANTENNE RF

(43) Date of publication of application: 23.10.2002
(73) Proprietor: TELEFONAKTIEBOLAGET LM ERICSSON (publ), 164 83 Stockholm (SE)
(72) Inventor: KAMPHUIS, Marc, Johan, Christian, NL-7661 PG Vasse (NL); VAN NIGTEVECHT, Hans, Christiaan, NL-7542 CG Enschede (NL)
(74) Representative: Dohmen, Johannes Maria Gerardus
(86) International application number: PCT/EP2000/000206
(87) International publication number: WO 2001/052357

(56) References cited:
- EP-A- 0 827 287
- EP-A- 0 844 485
- EP-A- 0 859 237
- US-A- 5 590 415
- US-A- 5 726 667

## Description

### Field of the Invention

The present invention relates to telecommunications systems and, more specifically, to equipment for transmitting and receiving radio communication signals.

### Background of the Invention

Modern radio transceiver devices for use in mobile and cordless telecommunications systems, such as the well-known cellular GSM (Global System for Mobile communication) and DECT (Digital Enhanced Cordless Telecommunications), for example, comprise highly sensitive semiconductor technology.

Transmitters of radio base stations or radio access units and portable radio terminals or radio communication units, such as radio telephones, comprise transmitters having RF transistor power amplifiers for transmitting RF power into antenna means connected to the power amplifier.

However, if the antenna means are not connected, the power amplifier can be destroyed due to excessive heat dissipation in the power amplifier during operation.

To avoid damaging of the power amplifier, in practice, at the output of the RF power amplifier Voltage Standing Wave Ratio (VSWR) measurements are performed, such as disclosed by European patent application 0 827 287. As is generally known by those skilled in the art, in the case of a proper impedance matched antenna connected to the RF power amplifier, the reflected wave energy is almost zero. Accordingly the VSWR, which is the ratio between the reflected wave and the incident wave provided by the RF power amplifier, is almost zero if the antenna is properly connected. In all other cases higher VSWR values will be measured.

Thus, by measuring the VSWR it can be detected whether an antenna is connected to the power amplifier or not. However, for use in radio access units and radio communication units, for which the commercial drivers, among others, are cost and size reduction, VSWR measurement circuitry are too expensive and too voluminous.

### Summary of the Invention

It is an object of the present invention to provide an RF antenna detector circuit, which is of a simple, less expensive and less space consuming construction. In particular for use in radio communications equi pment such as a radio access unit and radio communication unit for mobile or cordless radio communication systems.

It is a further object of the present invention to provide a radio access unit and a radio communication unit for use in radio communications systems, comprising such an RF antenna detector circuit in order to avoid destroyment of the RF power amplifier if during operation the antenna means are not or not properly connected.

According to the present invention, there is provided an RF antenna detector circuit, comprising a tuned circuit, having a first end comprising an RF power input terminal and a second end comprising an antenna output terminal, and a detection circuit connected to the first end of the tuned circuit, characterized in that the tuned circuit is arranged for producing, during operation, at the first end of the tuned circuit a specific RF signal level to be detected by the detection circuit indicative of a failure of an antenna connected to the antenna output terminal.

Contrary to VSWR measurement, the RF antenna detector circuit according to the invention is arranged for producing a specific RF signal level in the absence of an antenna connected to the antenna output terminal, for example. By detecting the presence of this RF signal level with the detection circuit provided, the absence of the antenna means can be simply established without having to perform ratio calculations and the like.

In a preferred embodiment of the RF antenna detector circuit according to the invention, the tuned circuit is a quarter-wave transmission line circuit with respect to the RF operating frequency, wherein the detection circuit is arranged for detecting a low RF signal level or a signal dip.

For use with modern radio communications devices operating in the Gigahertz range, the transmission line circuit is preferably a quarter-wave stripline circuit.

In an embodiment of the RF antenna detector circuit according to the invention, the voltage detection circuit comprises a rectifying element, wherein a first end of the rectifying element connects to the first end of the tuned circuit and a second end of the rectifying element provides a DC output terminal producing, during operation, a DC voltage dependent on the RF voltage level detected at the first end of the tuned circuit.

In a preferred embodiment of the invention, the detection circuit comprises a series connection of a resistor, a rectifying diode and a low pass filter circuit, such as a parallel circuit of a resistor and capacitor, for producing a smoothened DC voltage at the DC output terminal.

In order to avoid damages to a power amplifier connected to the RF power input terminal of the RF antenna detector circuit in the case of absence of or a failure in an antenna connected to the antenna output terminal, in a further embodiment of the invention, an inhibit circuit is provided for inhibiting RF power to be applied by the RF power amplifier to the RF power input terminal at the detection of the specific RF signal level.

The inhibit circuit may be arranged for switching off the RF power amplifier by detecting a low voltage or voltage dip at the DC output terminal of the RF antenna detector circuit in the absence of an antenna connected to the antenna output terminal, for example.

The invention further relates to a radio access unit and a radio communication unit of a radio communication system for wireless telecommunication, comprising transmitter, receiver and control means arranged for providing radio communication in accordance with a wireless radio communications standard, such as GSM or DECT, wherein the transmitter means comprise an RF antenna detector circuit as disclosed above, in particular comprising an inhibit circuit operative to inhibit a power amplifier (PA) of the transmitter means to transmit RF power to the RF antenna detector circuit.

The above-mentioned and other features and advantages of the invention are illustrated in the following description with reference to the enclosed drawings.

### Brief Description of the Drawings

Figure 1 shows a general block diagram of an RF antenna detector circuit according to the invention.
Figure 2 shows a preferred embodiment of the RF antenna detector circuit according to the invention.
Figures 3a and 3b show, in a schematic and illustrative manner, wave patterns at the tuned circuit of figure 2, with and without an antenna connected to the antenna output terminal, respectively.
Figure 4 shows a simplified block diagram of radio equipment provided with an RF antenna detector circuit according to the invention, for use in a radio communications system for wireless telecommunication.

### Detailed Description of the Embodiments

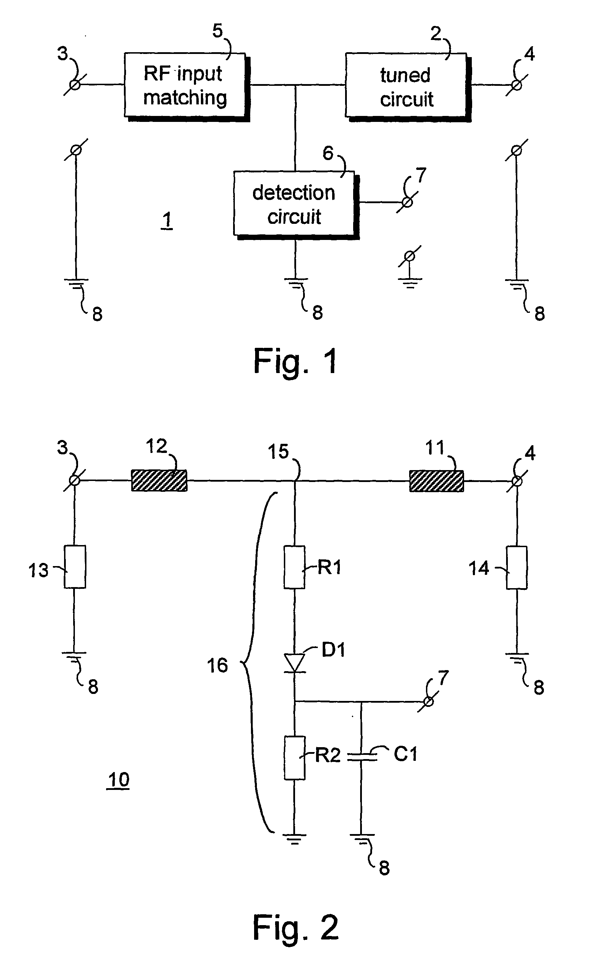

Figure 1 shows a general block diagram of an RF antenna detector circuit 1 according to the invention. The RF antenna detector circuit 1 comprises a tuned circuit 2, a first end of which connects to an RF power input terminal 3 and a second end of the tuned circuit 2 connects to an antenna output terminal 4.

Among others for impedance matching purposes, in the RF antenna detector circuit 1 shown, an RF input matching circuit 5 is connected between the RF power input terminal 3 and the first end of the tuned circuit 2.

The RF antenna detector circuit 1 further comprises a detection circuit 6, connected to the tuned circuit 2, for example to the first end thereof. The detection circuit 6 comprises a detection signal output terminal 7.

In the block diagram of the RF antenna detector circuit I shown in figure 1, the relevant input and output signals at the respective input and output terminals relate to a common signal ground 8, indicated by short parallel lines. However, those skilled in the art will appreciate that the circuit may also comprise input and output terminals, not having a common signal ground.

According to the invention, the tuned circuit 2 is arranged such that in the absence or a failure of an antenna connected to the antenna output terminal 4 a predefined RF signal level appears at the point at which the detection circuit 6 connects. That is, in the embodiment shown, the first end of the tuned circuit 2. By detection of this specific RF signal level, the detection circuit 6 provides an appropriate output signal at its detection signal output terminal 7.

For the purpose of the present invention, the output signal at the detection signal output terminal 7 can be applied to prevent damages to an RF power amplifier (not shown) connected to the RF power input terminal 3 of the RF antenna detector circuit 1. For example by inhibiting RF power to be fed into the RF antenna detector circuit 1 by switching off the power amplifier.

Figure 2 shows a preferred embodiment of the antenna detector circuit according to the invention, designated by reference numeral 10. In the embodiment shown, the tuned circuit 2 comprises a quarter-wave (λ/4) transmission line circuit 11 at the RF operating frequency, such as a quarter-wave stripline circuit for use in transmitter equipment operating at or near the GHz frequency range. The RF input matching circuit 5 likewise comprises a transmission line circuit 12, such as a stripline circuit. The length of the transmission line circuit 12 at the RF operating frequency is not critical and mainly chosen in order to optimize RF power transfer from a power amplifier 13, connected to the RF power input terminal 3, to antenna means 14 connected at the antenna output terminal 4 of the detector circuit 10. For the purpose of clarity, the power amplifier 13 and the antenna means 14 are represented by their impedances at the RF operating frequency of interest.

At the junction 15 between the transmission line circuits 11 and 12 a detection circuit 16 connects to signal ground 8. The detection circuit 16 comprises a series circuit of a resistor R1, a rectifying diode D1 and a Low Pass (LP) filter comprised by a parallel circuit of a resistor R2 and a capacitor C1. At the junction of the rectifying diode D1 and the LP filter R2//C1, the detection signal output terminal 7 connects.

The rectifying diode D1 is of the type for rectifying RF signals, whereas the resistor R1 is selected in order to minimize RF transmission power loss into the detection circuit 16.

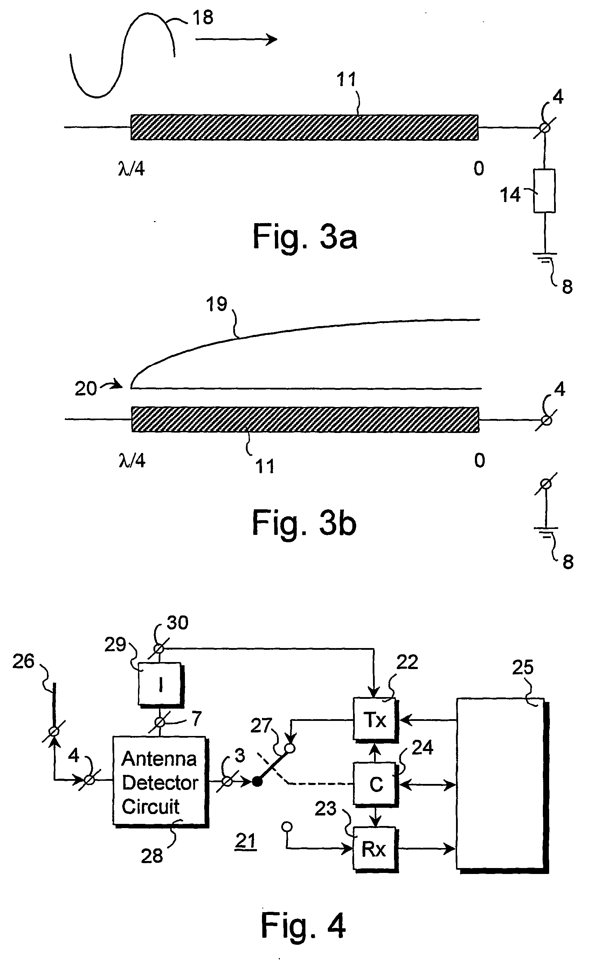

The operation of the RF antenna detector circuit 10 will now be explained with reference to figures 3a and 3b.

It is assumed that the transmission lines 11, 12 and the power amplifier 13 and antenna means 14 are impedance matched in order to achieve maximum RF power transfer from the RF power amplifier 13 into the antenna means 14.

If an antenna is connected to the antenna output terminal 4, substantially all RF power produced by the power amplifier 13 will be dissipated in the antenna 14 and, accordingly, radiated by the antenna 14. A travelling wave pattern will exist on the quarter-wave transmission line 11, as indicated by a travelling wave 18. See figure 3a.

In the absence of an antenna connected to the antenna output terminal 4, the transmission line 11 will be open at its second end. As a result, a standing wave pattern will exist on the transmission line 11, as indicated by reference numeral 19 in figure 3b.

The standing wave pattern 19 reaches a maximum in the RF signal voltage at the antenna output terminal 4 and a null or minimum or dip 20 in the RF signal voltage at a point λ/4 backwards from the antenna output terminal 4. That is, at the first end of the transmission line circuit 11, at a distance λ/4 backwards from the second end of the transmission line circuit 11. By measuring the RF voltage at the first end of the transmission line circuit 11, i.e. junction 15 in figure 1, absence or failure of the antenna means 14 is directly detected.

Those skilled in the art will appreciate that λ is the wavelength of the RF electromagnetic radiation by the antenna 14. For radio communication equipment operating at a radio frequency band, the transmission line 11 is tuned to the midfrequency of the radio frequency band, for example.

In the circuit of figure 2, in the case of a travelling wave pattern 18 over the transmission line 11 as shown in figure 3a, a DC voltage will be produced at the detection signal output terminal 7, equivalent to the RF voltage at the first end of the transmission line circuit 11 rectified by the rectifying diode D1 and smoothened by the LP filter provided by the parallel connection of resister R2 and capacitor C1. In the case of a standing wave pattern 19, as illustrated in figure 3b, the DC voltage produced at the detection signal output terminal 7 of the detection circuit 10 will have a value less than the DC voltage produced for a travelling wave pattern 18, that is with an antenna connected to the antenna output terminal 4.

Accordingly, by detection of a low DC voltage at the signal output terminal 7 of the detection circuit 10, the absence or failure of an antenna at the antenna output terminal 4 of the RF antenna detector circuit 10 is automatically detected.

The circuit shown in figure 2 is a very simple design requiring just a few components and, for example, a stripline 2 provided on a Printed Circuit Board (PCB) (not shown).

Accordingly, the RF antenna detector circuit according to the invention is less space and cost consuming, and excellent to use in modern radio equipment for mobile and cordless radio communication.

Figure 4 shows a simplified block diagram of radio communication equipment, such as a radio access unit, a radio relay unit or a radio communication unit for use in radio communications systems operating following a radio telecommunication standard such as the well-known analog and digital radio telephone standards designated AMPS, ETACS, NMT, GSM, CT0, CT1, CT2, CT3, PHS and DECT, for example.

The communication equipment 21 comprises transmitter means (Tx) 22, receiver means (Rx) 23, control means (C) 24 and further processing and input/output means 25, arranged for further processing of speech and data signals received from the receiver means 23 or to be transmitted by the transmitter means 22. In the case of a portable radio telephone, for example, the means 25 comprise audio amplifier, microphone and loudspeaker means, for example. In the case of a radio access unit, such as a radio base station, the means 25 comprise processor means for processing the relevant speech and data signals for communication purposes.

The control means 24 are arranged to connect antenna means 26 to either the transmitter means 22 or the receiver means 23 by operation of switching means 27, such as semiconductor switching means.

In accordance with the present invention, between the switching means 27 and the antenna means 26 an RF Antenna Detector Circuit 28 is connected, comprising an RF antenna detector circuit 1 or 10 disclosed above. At the detection signal output terminal 7 of the antenna detector circuit 28 an inhibit circuit (I) 29 connects, a control output 30 of which controls the operation of the transmitter means 22. The inhibit circuit 29 is arranged to inhibit RF power to be applied to the RF power input terminal 3 of the antenna detector circuit 28 if the absence or failure of antenna means 26 at the antenna output terminal 4 is detected. This, for example, by switching off the power amplifier of the transmitter means 22.

The inhibit circuit 29 may comprise a simple flip flop circuit or the like, providing a control signal if the voltage level at the detection signal output terminal 7, during operation, is below a set value. This, in order to avoid damaging of the power amplifier of the transmitter means 22.

Although the invention is particularly disclosed for a tuned circuit taking the form of a quarter-wave transmission line, those skilled in the art will appreciate that other tuned circuits can be applied providing a specific RF signal level in the absence of an antenna load.

With respect to the theory of electromagnetic radiation on transmission line circuits, reference is made to the "Antenna Engineering Handbook", third edition, McGraw-Hill.

The invention is further not limited to its use in radio base station or radio access equipment, radio relay equipment and/or radio communication terminal equipment for use in mobile or cordless radio communications systems.

## Claims

1. An RF antenna detector circuit (1), comprising a tuned circuit (2), having a first end comprising an RF power input terminal (3) and a second end comprising an antenna output terminal (4), and a detection circuit (6) connected to said first end of said tuned circuit (2), **characterized in that** said tuned circuit (2) is arranged for producing, during operation, at said first end of said tuned circuit (2) a specific RF signal level to be detected by said detection circuit (6) indicative of a failure of an antenna (14) connected to said antenna output terminal (4).

2. An RF antenna detector circuit (1) according to claim 1, wherein said tuned circuit (2) is a quarter-wave transmission line circuit (11), and said detection circuit (6) is arranged for detecting a low RF signal level or a signal dip at said first end of said tuned circuit (2).

3. An RF antenna detector circuit (1) according to claim 2, wherein said quarter-wave transmission line circuit (11) is a quarter-wave stripline circuit.

4. An RF antenna detector circuit (1) according to claim 1, 2 or 3, wherein said first end of said tuned circuit (2) connects to said RF power input terminal (3) by an RF input matching circuit (5).

5. An RF antenna detector circuit (1) according to claim 4, wherein said RF input matching circuit (5) comprises a transmission line circuit (12), such as a stripline circuit.

6. An RF antenna detector circuit (1) according to any of the previous claims, wherein said detection circuit (16) comprises a rectifying element, a first end of which connects to said first end of said tuned circuit (2), and a second end of said rectifying element provides a DC output terminal (7) producing, during operation, a DC voltage dependent on the RF voltage level at said first end of said tuned circuit (2).

7. An RF antenna detector circuit (1) according to claim 6, wherein said detection circuit (16) comprises a series connection of a resistor (R1), a rectifying diode (D1) and a low pass filter circuit (R2,C1) for producing a smoothened DC voltage at the DC output terminal (7).

8. An RF antenna detector circuit (28) according to any of the previous claims, further comprising an inhibit circuit (29), connected to said detection circuit (28), for inhibiting RF power to be applied to said RF power input terminal (3) at the detection of said specific RF signal level.

9. A radio access unit (21) of a radio communications system for wireless telecommunication, comprising transmitter (22), receiver (23) and control means (24), arranged for providing radio communication in accordance with a wireless radio communications standard, said transmitter means (22) comprise an RF antenna detector circuit (28) according to any of the claims 1-8.

10. A radio access unit according to claim 9 comprising an inhibit circuit (29) according to claim 8, wherein said inhibit circuit (29) is operative to inhibit a Power Amplifier (PA) of said transmitter means (22) to transmit RF power to said RF antenna detector circuit (28).

11. A portable radio communication unit (21) of a radio communications system for wireless telecommunication, comprising transmitter (22), receiver (23) and control means (24), arranged for providing radio communication in accordance with a wireless radio communications standard, said transmitter means (22) comprise an RF antenna detector circuit (28) according to any of the claims 1-8.

12. A portable radio communication unit (21) according to claim 11, comprising an inhibit circuit (29) according to claim 8, wherein said inhibit circuit (29) is operative to inhibit a Power Amplifier (PA) of said transmitter means (22) to transmit RF power to said RF antenna detector circuit (28).

## Patentansprüche

1. HF-Antennendetektorschaltung (1), die eine abgestimmte Schaltung (2) mit einem ersten Ende, das einen HF-Leistungseingangsanschluss (3) aufweist, und einem zweiten Ende, das einen Antennenausgangsanschluss (4) aufweist, und eine Erfassungsschaltung (6), die mit dem ersten Ende der abgestimmten Schaltung (2) verbunden ist, aufweist, **dadurch gekennzeichnet, dass** die abgestimmte Schaltung (2) zum während eines Betriebs Erzeugen eines durch die Erfassungsschaltung (6) zu erfassenden spezifischen HF-Signalpegels, der einen Fehler einer Antenne (14), die mit dem Antennenausgangsanschluss (4) verbunden ist, anzeigt, an dem ersten Ende der abgestimmten Schaltung (2) angeordnet ist.

2. HF-Antennendetektorschaltung (1) nach Anspruch 1, bei der die abgestimmte Schaltung (2) eine Viertelwellen-Übertragungsleitungsschaltung (11) ist und die Erfassungsschaltung (6) zum Erfassen eines niedrigen HF-Signalpegels oder einer Signalsenke an dem ersten Ende der abgestimmten Schaltung (2) angeordnet ist.

3. HF-Antennendetektorschaltung (1) nach Anspruch 2, bei der die Viertelwellen-Übertragungsleitungsschaltung (11) eine Viertelwellen-Streifenleitungsschaltung ist.

4. HF-Antennendetektorschaltung (1) nach Anspruch 1, 2 oder 3, bei der das erste Ende der abgestimmten Schaltung (2) durch eine HF-Eingangsanpassungsschaltung (5) mit dem HF-Leistungseingangsanschluss (3) verbunden ist.

5. HF-Antennendetektorschaltung (1) nach Anspruch 4, bei der die HF-Eingangsanpassungsschaltung (5) eine Übertragungsleitungsschaltung (12), wie eine Streifenleitungsschaltung, aufweist.

6. HF-Antennendetektorschaltung (1) nach einem der vorhergehenden Ansprüche, bei der die Erfassungsschaltung (16) ein gleichrichtendes Element aufweist, wobei ein erstes Ende desselben mit dem ersten Ende der abgestimmten Schaltung (2) verbunden ist und ein zweites Ende des gleichrichtenden Elements einen Gleich-Ausgangsanschluss (7) liefert, der während eines Betriebs eine Gleichspannung erzeugt, die von dem HF-Spannungspegel an dem ersten Ende der abgestimmten Schaltung (2) abhängt.

7. HF-Antennendetektorschaltung (1) nach Anspruch 6, bei der die Erfassungsschaltung (16) eine Reihenschaltung eines Widerstands (R1), einer gleichrichtenden Diode (D1) und einer Tiefpassfilterschaltung (R2,C1) zum Erzeugen einer geglätteten Gleichspannung an dem Gleich-Ausgangsanschluss (7) aufweist.

8. HF-Antennendetektorschaltung (28) nach einem der vorhergehenden Ansprüche, die ferner eine Sperrschaltung (29), die mit der Erfassungsschaltung (28) verbunden ist, zum Sperren einer HF-Leistung, die bei der Erfassung des spezifischen HF-Signalpegels an den HF-Leistungseingangsanschluss (3) anzulegen ist, aufweist.

9. Funkzugangseinheit (21) eines Funkkommunikationssystems für eine drahtlose Telekommunikation, die eine Sender-, (22), eine Empfänger- (23) und eine Steuerungseinrichtung (24) aufweist, die zum Liefern einer Funkkommunikation gemäß einem Standard für drahtlose Funkkommunikationen angeordnet sind, wobei die Sendereinrichtung (22) eine HF-Antennendetektorschaltung (28) nach einem der Ansprüche 1-8 aufweist.

10. Funkzugangseinheit nach Anspruch 9, die eine Sperrschaltung (29) nach Anspruch 8 aufweist, wobei die Sperrschaltung (29) wirksam ist, um einen Leistungsverstärker (PA) der Sendereinrichtung (22) dahingehend zu sperren, eine HF-Leistung zu der HF-Antennendetektorschaltung (28) zu übertragen.

11. Tragbare Funkkommunikationseinheit (21) eines Funkkommunikationssystems für eine drahtlose Telekommunikation, die eine Sender- (22), eine Empfänger- (23) und eine Steuerungseinrichtung (24) aufweist, die zum Liefern einer Funkkommunikation gemäß einem Standard für drahtlose Funkkommunikationen angeordnet sind, wobei die Sendereinrichtung (22) eine HF-Antennendetektorschaltung (28) nach einem der Ansprüche 1-8 aufweist.

12. Tragbare Funkkommunikationseinheit (21) nach Anspruch 11, die eine Sperrschaltung (29) nach Anspruch 8 aufweist, wobei die Sperrschaltung (29) wirksam ist, um einen Leistungsverstärker (PA) der Sendereinrichtung (22) dahingehend zu sperren, eine HF-Leistung zu der HF-Antennendetektorschaltung (28) zu übertragen.

## Revendications

1. Circuit détecteur d'antenne RF (1), comportant un circuit accordé (2), ayant une première extrémité comportant une borne (3) d'entrée d'énergie RF et une seconde extrémité comportant une borne (4) de sortie d'antenne, et un circuit de détection (6) connecté à ladite première extrémité dudit circuit accordé (2), **caractérisé en ce que** ledit circuit accordé (2) est agencé pour produire, pendant le fonctionnement, à ladite première extrémité dudit circuit accordé (2), un niveau de signal RF spécifique devant être détecté par ledit circuit de détection (6) représentatif d'une défaillance d'une antenne (14) connectée à ladite borne (4) de sortie d'antenne.

2. Circuit détecteur d'antenne RF (1) selon la revendication 1, dans lequel ledit circuit accordé (2) est un circuit (11) de ligne de transmission quart d'onde, et ledit circuit de détection (6) est agencé pour détecter un niveau de signal RF bas ou une chute de signal à ladite première extrémité dudit circuit accordé (2).

3. Circuit détecteur d'antenne RF (1) selon la revendication 2, dans lequel ledit circuit (11) de ligne de transmission quart d'onde est un circuit triplaque quart d'onde.

4. Circuit détecteur d'antenne RF (1) selon la revendication 1, 2 ou 3, dans lequel ladite première extrémité dudit circuit accordé (2) est connectée à ladite borne (3) d'entrée d'énergie RF par un circuit (5) d'adaptation d'entrée RF.

5. Circuit détecteur d'antenne RF (1) selon la revendication 4, dans lequel ledit circuit (5) d'adaptation d'entrée RF comporte un circuit (12) de ligne de transmission, tel qu'un circuit triplaque.

6. Circuit détecteur d'antenne RF (1) selon l'une quelconque des revendications précédentes, dans lequel ledit circuit de détection (16) comporte un élément redresseur, dont une première extrémité est connectée à ladite première extrémité dudit circuit accordé (2), et une seconde extrémité dudit élément redresseur fournit une borne (7) de sortie continue produisant, pendant le fonctionnement, une tension continue qui dépend du niveau de tension RF à ladite première extrémité dudit circuit accordé (2).

7. Circuit détecteur d'antenne RF (1) selon la revendication 6, dans lequel ledit circuit de détection (16) comporte une connexion en série d'une résistance (R1), d'une diode redresseuse (D1) et d'un circuit de filtre passe-bas (R2, C1) pour la production d'une tension continue lissée à la borne (7) de sortie continue.

8. Circuit détecteur d'antenne RF (28) selon l'une quelconque des revendications précédentes, comportant en outre un circuit d'inhibition (29), connecté audit circuit de détection (28), pour empêcher l'application d'énergie RF à ladite borne (3) d'entrée d'énergie RF à la détection dudit niveau de signal RF spécifique.

9. Unité d'accès radio (21) d'un système de communications radio pour télécommunication sans fil, comportant un émetteur (22), un récepteur (23) et un moyen de commande (24), agencés pour établir une communication radio conformément à une norme de communications radio sans fil, ledit moyen émetteur (22) comportant un circuit détecteur d'antenne RF (28) selon l'une quelconque des revendications 1 à 8.

10. Unité d'accès radio selon la revendication 9, comportant un circuit d'inhibition (29) selon la revendication 8, dans lequel ledit circuit d'inhibition (29) a pour fonction d'empêcher un amplificateur de puissance (PA) dudit moyen émetteur (22) de transmettre de l'énergie RF audit circuit détecteur d'antenne RF (28).

11. Unité portable (21) de communications radio pour un système de communications radio pour télécommunication sans fil, comportant un émetteur (22), un récepteur (23) et un moyen de commande (24), agencés pour établir une communication radio conforme à une norme de communications radio sans fil, ledit moyen émetteur (22) comportant un circuit détecteur d'antenne RF (28) selon l'une quelconque des revendications 1 à 8.

12. Unité portable (21) de communications radio selon la revendication 11, comportant un circuit d'inhibition (29) selon la revendication 8, dans laquelle ledit circuit d'inhibition (29) a pour fonction d'empêcher un amplificateur de puissance (PA) dudit moyen émetteur (22) de transmettre de l'énergie RF audit circuit détecteur d'antenne RF (28).
